# EUROPÄISCHE PATENTANMELDUNG

(11) **EP 1 014 714 A1**
(43) Veröffentlichungstag der Anmeldung: **28.06.2000**
(21) Anmeldenummer: 99124608.3
(22) Anmeldetag: 10.12.1999
(51) Int. Cl.: H04N 5/50, H03J 1/00

(54) **TV-Empfänger**

(30) Priorität: 19.12.1998 DE 19858867
(71) Anmelder: BECKER GmbH, D-76307 Karlsbad (DE)
(72) Erfinder: Schäfer, Peter, 75438 Knittlingen (DE); Link, Hermann, 78166 Donaueschingen (DE); Zahm, Michael, 76337 Waldbronn (DE)
(74) Vertreter: Patentanwälte Westphal, Mussgnug & Partner

(57) **Zusammenfassung**

Die Erfindung betrifft einen TV-Empfänger (1) mit einem Anschluß (2) für eine TV-Antenne (3), mit einem TV-Tuner zur Decodierung und Verstärkung des über den Anschluß (2) für die TV-Antenne (3) zugeführten TV-Empfangssignals. Der TV-Empfänger (1) zeigt zusätzlich eine Steuereinheit (5) für die Steuerung des TV-Tuners (4) und einen GPS-Empfänger (6), der mit der Steuereinheit (5) verbunden ist und der die Lage des TV-Empfängers (1) ausgehend von dem GPS-Empfangssignal bestimmt und diese Lage der Steuereinheit (5) übermittelt. Diese steuert dann abhängig von der Lageinformation des TV-Empfängers in Verbindung mit den in einem Speicher (7) abgelegten ortsabhängigen Informationen zur jeweiligen Empfangslage, das können die relevanten TV-Standards oder die empfangbaren TV-Kanäle umfassen, den TV-Tuner (4) dahingehend, daß ein sehr schnelles Abstimmen des TV-Tuners (4) bzw. ein sehr schneller Senderdurchlauf des TV-Tuners (4) bei einem geänderten Ort, beispielsweise bei einer Erstinbetriebnahme oder an verschiedenen räumlich getrennten Aufstellorten erreicht ist. Dadurch ist die Benutzerfreundlichkeit des TV-Empfängers merklich verbessert.

## Beschreibung

Die Erfindung betrifft ein TV-Empfänger mit einem Anschluß für die Zuführung eines Fernsehsignals von einer TV-Antenne mit einem TV-Tuner zur Decodierung und zur Verstärkung der über den Anschluß zugeführten TV-Empfangssignale und mit einer Steuereinheit zur Steuerung des TV-Tuners.

Es sind TV-Empfänger bekannt, die bei der Erstinbetriebnahme von Hand abgestimmt werden müssen, und die das empfangene TV-Signal mittels eines TV-Tuners decodieren und verstärken und anschließend zur Wiedergabe auf den Bildschirm bringen. Dabei wird mittels eines Einstellknopfes die Kanaleinstellung unter Mithilfe einer Steuereinheit des TV-Empfängers vorgenommen. Dabei wird jeweils die Wiedergabequalität am Bildschirm als Maß für das TV-Empfangssignal und für die Qualität der Decodierung bzw. der Verstärkung herangezogen und abhängig davon die Kanaleinstellung beibehalten oder eine andere Kanal-einstellung gewählt. Derartige TV-Empfänger erweisen sich in der Einstellung als sehr umständlich und benötigen eine sehr lange Zeit für eine befriedigende Zuordnung der TV-Empfangskanäle zu den einzelnen Programmwahltasten.

Weiterhin sind TV-Empfänger bekannt, welche im Rahmen eines automatischen Suchlaufs über das gesamte Frequenzband die an dem Ort empfangbaren TV-Kanäle selektieren und im Rahmen der Selektion diese nach der Empfangsqualität beurteilen. Dieser Sendersuchlauf wird durch die Steuereinheit des TV-Empfängers vorgenommen. Dieser Sendersuchlauf benötigt eine ausgesprochen lange Zeit, da für jedes TV-Empfangssignal eine Vielzahl von Decodierungen aus den möglichen Codierungsarten gemäß den verschiedenen weltweiten TV-Farb- und Schwarz-Weiß-Standards vorgenommen werden muß bis die korrekte Codierung und damit die Möglichkeit einer aussagekräftigen Qualitätsbewertung gegeben ist.

Der Erfindung liegt die Aufgabe zugrunde, einen TV-Empfänger zu schaffen, welcher möglichst schnell die an einem Ort empfangbaren TV-Kanäle ermitteln oder einstellen kann.

Diese Aufgabe wird erfindungsgemäß durch einen TV-Empfänger mit den Merkmalen des Anspruchs 1 gelöst.

Vorteilhafte Weiterbildungen ergeben sich aus den Unteransprüchen.

Nach der Erfindung ist der TV-Empfänger mit einem GPS-Empfänger verbunden, welcher GPS-Antennensignale von einer GPS-Antenne zugeführt bekommt und aus den GPS-Antennensignalen eine Ortsinformation ableitet, welche durch den TV-Empfänger dazu benutzt wird, bestimmte für diese Ort nicht relevante TV-Standards auszuschließen bzw. bestimmte Empfangskanäle, welche für diesen Ort nicht relevant sind, auszuschließen. Dadurch wird es möglich, daß das Abstimmen bzw. das Auffinden der an diesem Ort tatsächlich empfangbaren TV-Kanäle von ausreichender Qualität wesentlich schneller vonstatten geht. Im Rahmen der Erfindung kann beispielsweise darauf verzichtet werden, daß abhängig von der durch den GPS-Empfänger detektierten Lage beispielsweise in Frankreich, eine Detektion eines Farbfernsehstandards nach NTSC-Standard nicht oder mit niedrigster Priorität versucht wird und damit die Abstimmung merklich verkürzt werden kann. Umgekehrt ist es nicht notwendig, bei einer detektierten Lage in den Vereinigten Staaten von Amerika eine Detektion nach dem SECAM-Standard, der im wesentlichen nur in Frankreich Verbreitung gefunden hat, vorzunehmen. Hier kann bevorzugt der NTSC-Standard als erster und bevorzugter Detektionsstandard Anwendung finden. Hierdurch kann einerseits durch den Ausschluß von bestimmten Codierungsstandards abhängig von der Lage und andererseits durch eine von der detektierten Lage abhängigen Reihenfolge der zu überprüfenden TV-Standards ein schnelles und effizientes Abstimmen auf empfangbare TV-Kanäle und damit ein sehr schneller Sendersuchlauf vorgenommen werden. Dies um so mehr, wenn zusätzlich bestimmte Frequenzbereiche abhängig vom Ort nicht auf das Vorhandensein von empfangbaren TV-Kanälen untersucht werden müssen.

Nach einer bevorzugten Ausführungsform der Erfindung zeigt der TV-Empfänger einen Speicher, in dem eine Tabelle einbeschrieben ist, in der bestimmten Ortsinformationen Informationen über die an dem Ort relevanten TV-Standards und/oder Information über die an dem Ort empfangbaren TV-Kanäle zugeordnet sind. Wird nun durch den GPS-Empfänger die Lage des TV-Empfängers bestimmt und diese Ortsinformation an die Steuereinheit weitergegeben, so wird aus dem Speicher mit der darin enthaltenen TV-Standardtabelle bzw. TV-Kanaltabelle, die dieser Lage des TV-Empfängers entsprechende Auswahl an relevanten TV-Standards bzw. soweit vorhanden auch die am Ort des TV-Empfängers empfangbare TV-Kanäle vorzugsweise mit einer Angabe zu deren TV-Standard entnommen und bei der Steuerung des TV-Tuners berücksichtigt. Dadurch wird sichergestellt, daß bei einem Sendersuchlauf oder bei einem Abstimmvorgang auf einen bestimmten TV-Kanal unnötige weil irrelevante Detektionsversuche mit nichtrelevanten TV-Standards bzw. durch den Wegfall unnötiger Abstimmversuche auf nicht belegte TV-Kanäle vermieden werden und damit eine erhebliche Beschleunigung der Abstimmung bzw. des Sendersuchlaufs gegeben ist.

Nach einer besonders bevorzugten Ausführungsform der Erfindung zeigt die in dem Speicher abgelegte Tabelle neben den an einem bestimmten Ort empfangbaren TV-Kanäle auch eine Information zur bevorzugten Empfangsrichtung für einen bestimmten TV-Kanal. Abhängig von dieser Information wird dann in Kenntnis nicht nur der Lage des TV-Empfängers sondern auch dessen räumliche Orientierung durch den GPS-Empfänger mittels der Steuerung eine Einstellvorrichtung für die TV-Antenne so angesteuert, daß die optimale Empfangsrichtung der Antenne für diesen bestimmten TV-Kanal eingestellt wird. Damit gelingt es nun nicht nur einen unbefriedigenden Kompromiß für eine Ausrichtung der TV-Antenne für den Empfang der verschiedenen an diesem Ort empfangbaren TV-Kanäle festzulegen, sondern stets für jeden TV-Kanal die optimale Ausrichtung der TV-Antenne einzustellen. Damit ist gewährleistet, daß die TV-Antenne regelmäßig auf den für einen TV-Kanal besten Sendeturm oder Satellit eingerichtet wird. Dabei wird gerade durch die Möglichkeit, daß der GPS-Empfänger die Orientierung des TV-Empfängers bzw. seiner Antenne feststellen kann, ermöglicht, daß ein derartiger TV-Empfänger an verschiedenen Orten im Ferienhaus, im Wohnwagen oder zu Hause stets den optimalen Empfang gewährleistet, wobei dies ohne also aufwendige und langwierige Einstellprozedur ermöglicht wird. Dabei kann dieser Abstimm- und Suchlaufvorgang vollautomatisch ohne zusätzlichen Eingriff von außen durch den Benutzer erfolgen. Insbesondere ist es auch möglich, daß ein derartiger Suchlauf- oder Abstimmvorgang automatisch angestoßen wird, sobald der GPS-Empfänger eine relevante Ortsveränderung des TV-Empfängers detektiert und der TV-Empfänger in Betrieb genommen wird. Damit ist an jedem Ort ohne jegliche zusätzliche Aktivität eines Benutzers ein guter TV-Empfang ermöglicht.

Als sehr vorteilhaft hat sich erwiesen, den Speicher als Lesespeicher als sogenanntes ROM, PROM, Flash-ROM oder E²PROM auszubilden. In diesen Lesespeicher wird werksseitig im Rahmen des Herstellungsprozesses oder eines Wartungsprozesses oder Reparaturprozesses oder Up-Date-Prozesses die Tabelle mit den zu diesem Zeitpunkt bekannten Orts-TV-Standard bzw. Orts-TV-Kanäle-Beziehungen eingespeichert. Damit ist sichergestellt, daß diese abgespeicherten Daten dem Benutzer unverändert zu jedem Zeitpunkt zur Verfügung stehen können. Insbesondere erweisen sich diese Lesespeicher als völlig oder weitgehend unempfindlich gegen eine Unterbrechung der Stromversorgung. Dies ist gerade dann von Vorteil, wenn das Gerät von einem Ort zum andern transportiert wird, beispielsweise wenn im Rahmen einer Urlaubsreise ein guter Empfang sowohl zu Hause als auch in der Ferienwohnung gewährleistet wird. Dabei ist es ohne Belang, daß der Fernseher während des Transportes ohne Stromversorgung ist, da der TV-Empfänger auch in einem solchen Fall die im Speicher abgelegte Tabelle ohne Verluste bewahren kann. Wird der TV-Empfänger am Zielort mit Strom versorgt, so wird er anhand der Informationen des GPS-Empfängers seinen Sendersuchlauf und Abstimmprozeß starten und die an dem Urlaubsort relevanten TV-Kanäle schnell und effizient ermitteln und den TV-Empfänger darauf abstimmen und gegebenenfalls eine entsprechende Programmierung der Programmwahltasten vornehmen.

Eine bevorzugte Ausführungsform der Erfindung zeigt neben dem Lesespeicher einen zusätzlichen beschreibbaren Speicher (RAM), in dem zusätzliche ortsspezifische Informationen eingespeichert werden können, die über die im Lesespeicher (ROM) abgelegten spezifischen Daten hinausgehen. Beispielsweise können dies an einem bestimmten Ort empfangbaren TV-Kanäle sein, insbesondere dann, wenn die Tabelle in dem Lesespeicher nur Informationen über die relevanten TV-Standards enthält. Weiterhin ist es möglich, daß in dem RAM die Änderungen in der Empfangslage an einem bestimmten Ort relativ den im ROM abgelegten ortsspezifischen Informationen abgespeichert werden können. Dies schafft somit die Möglichkeit, daß dieser selbstlernende TV-Empfänger stets die Veränderung in der Empfangslage aufgrund der zeitlichen Veränderung an einem Ort und/oder aufgrund der räumlichen Änderung abspeichert und später berücksichtigt. Damit ist ein regelmäßiges Up-Date des ROM's im Rahmen einer Reparatur oder eines festen Up-Date-Zyklus nicht mehr erfor-derlich. Insofern erweist sich ein derartiger selbstlernender TV-Empfänger mit RAM als sehr benutzerfreundlich. Diese im RAM abgelegten zusätzlichen ortsspezifischen Informationen werden bei der Steuerung des TV-Tuners bzw. bei der Ausrichtung einer TV-Antenne herangezogen, was somit stets einen optimierten Empfang bei schneller und effizienter Abstimmung ermöglicht.

Ein derartiger selbstlernender TV-Empfänger ermöglicht es sogar, daß bei einem mobilen Einsatz des TV-Empfängers die Empfangslage des TV-Empfängers entlang der gefahrenen Strecke abgespeichert wird und diese abgespeicherten Informationen bei einer späteren Fahrt auf dieser Strecke wieder abgerufen und verwendet wird und dadurch ein umfangreiches Abstimmen nicht mehr notwendig ist. Damit kann jeweils auf optimale Weise direkt auf den relevanten TV-Kanal und gegebenenfalls mit entsprechender Ausrichtung der TV-Antenne direkt umgeschaltet werden. Auf ein aufwendiges Abstimmen bzw. einen aufwendigen Sendersuchlauf des TV-Empfängers kann in diesem Fall verzichtet werden. Gerade bei dem mobilen Einsatz des erfindungsgemäßen TV-Empfängers zeigen sich seine besonderen Qualitäten, da sich hier die Empfangslagen stetig ändern und dabei starke Veränderungen der Empfangslage gegeben sind.

Vorzugsweise ist die GPS-Antenne und der dieser zugeordnete GPS-Empfänger vom übrigen TV-Empfänger abgesetzt ausgebildet und insbesondere an einem Ort angeordnet, der eine freie Sicht zum Himmel und damit zu den im Orbit befindlichen GPS-Satelliten zeigt. Damit ist gewährleistet, daß eine ausreichende Empfangslage für den GPS-Empfänger gegeben ist und dadurch eine ausreichende Information zur genauen Feststellung des Ortes des GPS-Empfängers respektive GPS-Antenne und damit des TV-Empfängers erzielt wird. Davon abgesetzt wird der restliche TV-Empfänger vorzugsweise im Bereich der TV-Antenne angeordnet. Die TV-Antenne ist häufig als Antenne für den terrestrischen Empfang ausgebildet und unterscheidet sich somit in ihrer Empfangscharakteristik gänzlich von der GPS-Antenne, weshalb sie an einem für sie optimierten Ort beispielsweise geschützt durch ein Dach oder im Innenraum von Ferienwohnungen untergebracht ist. Durch die enge räumliche Verknüpfung zwischen GPS-Antenne und GPS-Empfänger sowie TV-Antenne und restlichem TV-Empfänger ist zudem gewährleistet, daß die sehr schwachen Antennensignale nur über sehr kurze Strecken über-tragen werden müssen und danach in dem GPS-Empfänger bzw. im TV-Tuner nur wenig geschwächt decodiert, verstärkt und weiterverarbeitet werden und dann als verstärkte Signale der weiteren Bestimmung zugeführt werden müssen. Damit ist erreicht, - daß eine äußere störende Beeinflussung der Empfangssignale mit dem Ergebnis einer deutlichen Verschlechterung des Signalrauschverhältnisses auf dem Wege von der Antenne zum GPS-Empfänger bzw. zum TV-Tuner weitgehend ausgeschlossen ist.

Dadurch ist auch eine wechselseitige Beeinflussung des GPS-Empfängers durch den restlichen TV-Empfänger und umgekehrt aufgrund der räumlichen Trennung ausgeschlossen. Dies stellt insgesamt eine sehr sichere Ortserkennung und damit ein sehr zügiges Abstimmverhalten und damit auch ein sehr guten Empfang sicher. Dabei ist der GPS-Empfänger mit dem restlichen TV-Empfänger und der insbesondere mit der Steuereinheit vorzugsweise über eine optische Datenleitung verbunden, welche ergänzend auch zur Übertragung anderer Daten beispielsweise als Teil eines Netzwerkes verwendet werden kann. Gerade durch die Ausbildung der Datenleitung als optische Datenleitung ist sichergestellt, daß eine Beeinflussung der übertragenen Daten durch äußere elektromagnetische Felder ausgeschlossen ist und dadurch ein sehr sicherer Betrieb des TV-Empfängers mit GPS-Empfänger erreicht ist.

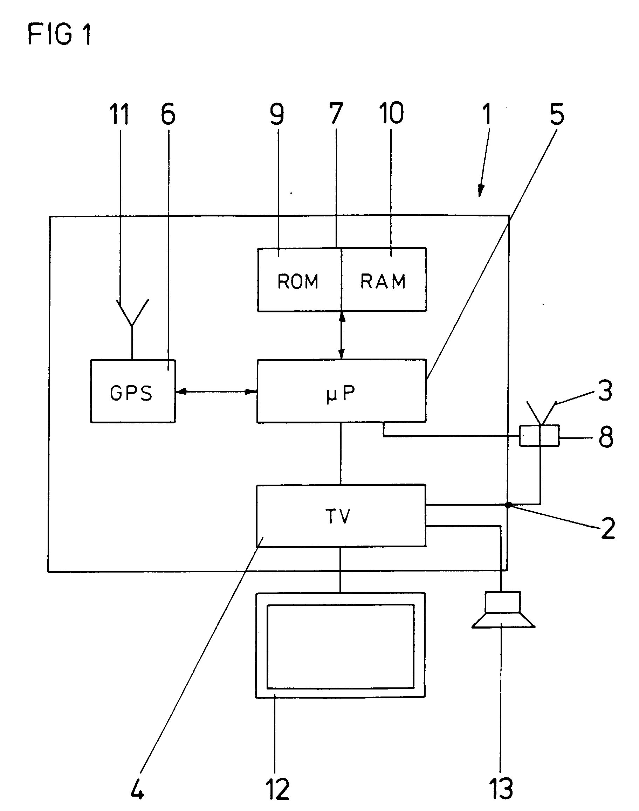

Ein bevorzugtes Ausführungsbeispiel der Erfindung ist in Figur 1 dargestellt und wird im folgenden näher beschrieben.

Der dargestellte TV-Empfänger 1 zeigt eine Steuereinheit 5, die einen TV-Tuner 4 steuert. Der Steuereinheit 5 ist ein GPS-Empfänger 6 zugeordnet und über eine elektrische Verbindungsleitung mit diesem verbunden. Dem GPS-Empfänger 6 ist eine GPS-Antenne 11 zugeordnet, welche die Signale der GPS-Satelliten im Orbit aufnimmt und an den GPS-Empfänger 6 weiterleitet. Diese GPS-Antennensignale werden im GPS-Empfänger 6 verstärkt, decodiert und in eine Ortsinformation umgewandelt. Diese Ortsinformation wird über die Verbindungsleitung an die Steuereinheit 5 übertragen.

Der TV-Empfänger 1 zeigt weiterhin einen Speicher 7, der aus einem ROM 9 und einem RAM 10 besteht. Dieser Speicher 7 ist mit der Steuereinheit 5 verbunden. In dem ROM 9 sind in Form einer Tabelle ortskorreliert, die an dem betreffenden Ort relevanten TV-Standards werksseitig einbeschrieben. Anhand dieser im ROM 9 abgespeicherten für einen bestimmten Ort relevanten TV-Standard kann die Steuereinheit 5 den TV-Tuner 4 so ansteuern, daß dieser ohne unnötige Überprüfung der anderen nichtrelevanten TV-Standars sehr effizient die Empfangslage an dem durch den GPS-Empfänger 6 detektierten Ort des TV-Empfängers 1 bestimmt und die mit ausreichender Qualität empfangbaren TV-Kanäle in dem RAM 10 abspeichert. Damit entsteht parallel zu der im ROM 9 abgespeicherten Tabelle in dem RAM 10 eine abgespeicherte, ergänzende Tabelle, in der zu einem bestimmten Ort die mit ausreichender Qualität empfangbaren TV-Kanäle abgelegt wird.

Dem TV-Tuner 4 ist eine TV-Antenne 3 zugeordnet, die das TV-Empfangssignal über den Anschluß 2 an den TV-Tuner 4 überträgt. Die TV-Antenne 3 ist mit einer Einstellvorrichtung 8 versehen, mit deren Hilfe die Orientierung der TV-Antenne verändert werden kann und dadurch für einen TV-Kanal ein optimiertes Empfangssignal erreicht werden kann. Diese Einstellvorrichtung 8 für die TV-Antenne 3 wird durch die Steuereinheit 5 so angesteuert, daß das dem TV-Tuner 4 zugeführte TV-Empfangssignal für den eingestellten TV-Kanal mit möglichst guter Empfangsqualität empfangen wird. Die Daten zur Ansteuerung der Einstellvorrichtung 8 für den optimalen Empfang eines bestimmten TV-Kanals werden neben dem im RAM 10 abgespeicherten Empfangsdaten - wie Empfangsfrequenzen des TV-Kanal und zugehöriger TV-Standard und ähnliche - ergänzend mit abgespeichert. Dadurch ist sichergestellt, daß der TV-Empfänger 1 in Zukunft sehr schnell auf die für diesen Ort relevanten Empfangsverhältnisse einschließlich der optimierten Ausrichtung der TV-Antenne 1 durch die Einstellvorrichtung 8 eingestellt werden kann. Damit ist gewährleistet, daß der TV-Empfänger 1 bei der Detektion eines Ortes, an dem der TV-Empfänger schon zuvor die Empfangslage untersucht und die relevanten Daten im RAM 10 abgespeichert hat, stets auf diese Daten unmittelbar zurückgreifen kann. Auch kann eine feste Zuordnung der an diesem Ort mit guter Qualität empfangbaren TV-Kanäle einschließlich der Ausrichtung der TV-Antenne 3 zu den Programmtasten des TV-Empfängers 1 vorgesehen werden. In diesem Falle kann auf einen Suchlauf über das Frequenzband ver zichtet werden, da auf die Information aus der Vergangenheit insbesondere auf die im RAM 10 abgelegten Daten wie auch auf die Daten in dem ROM 9 zurückgegriffen werden kann.

Der TV-Tuner 4 ist mit einem vom TV-Empfänger 1 abgesetzten Lautsprecher 13 verbunden. Über diesen Lautsprecher 13 werden die Audiosignale des empfangenen TV-Signals ausgegeben, während die Videosignale mittels einer vom Empfänger 1 abgesetzten Bildausgabeeinheit 12 dem Zuschauer zur Verfügung gestellt werden.

### Bezugszeichenliste

- 1: TV-Empfänger
- 2: Anschluß für die TV-Antenne
- 3: TV-Antenne
- 4: TV-Tuner
- 5: Steuereinheit
- 6: GPS-Empfänger
- 7: Speicher
- 8: Einstellvorrichtung für TV-Antenne 3
- 9: Lesespeicher (ROM)
- 10: beschreibbarer Speicher (RAM)
- 11: GPS-Antenne
- 12: Bildausgabeeinheit
- 13: Lautsprecher

## Patentansprüche

1. TV-Empfänger (1) mit einem Anschluß (2) für wenigstens eine oder mehrere TV-Antenne (3) mit einem TV-Tuner (4) zur Decodierung und Verstärkung der über den Anschluß (2) für eine TV-Antenne (3) zugeführten TV-Empfangssignale, mit einer Steuereinheit (5) für die Steuerung des TV-Tuners (4) und mit einem GPS-Empfänger (6), der mit der Steuerung (5) zur ortsabhängigen Steuerung des TV-Tuners verbunden ist und dem GPS-Antennensignale zuführbar sind.

2. TV-Empfänger nach Anspruch 1,
**dadurch gekennzeichnet,** daß ein Speicher (7) vorgesehen ist, in dem eine Tabelle aus Ortsinformationen und an einem Ort relevante TV-Standards enthalten sind, und die Steuereinheit (5) abhängig von dem durch den GPS-Empfänger (6) dargestellten Ort einen oder mehrere relevante TV-Standards aus dem Speicher (7) entnehmbar und der TV-Tuner (4) auf diese relevanten TV-Standards einstellbar ist.

3. TV-Empfänger nach Anspruch 1 oder 2,
**dadurch gekennzeichnet,** daß ein Speicher (7) vorgesehen ist, in dem eine Tabelle aus Ortsinformationen und an einem Ort empfangbare TV-Kanäle enthalten ist, und die Steuereinheit (5) abhängig von dem durch den GPS-Empfänger (6) dargestellten Ort ein empfangbarer TV-Kanal aus dem Speicher (7) entnehmbar ist und der TV-Tuner (4) auf diesen TV-Kanal einstellbar ist.

4. TV-Empfänger nach einem der vorstehenden Ansprüche,
**dadurch gekennzeichnet,** daß ein Speicher (7) vorgesehen ist, in dem eine Tabelle aus Ortsinformationen, an einem Ort empfangbare TV-Kanäle sowie Informationen zur Ausrichtung einer TV-Antenne (3) entsprechend den empfangbaren TV-Kanäle enthalten ist, und durch die Steuereinheit (5) abhängig von dem durch den GPS-Empfänger (6) dargestellten Ort empfangbarer TV-Kanal aus dem Speicher (7) entnehmbar ist, der TV-Tuner (4) auf diesen TV-Kanal einstellbar ist und die TV-Antenne (3) entsprechend der Information zur Ausrichtung der TV-Antenne (3) in Abhängigkeit von den durch den GPS-Empfänger (6) dargestellten Ort und von dem gewählten einstellbaren TV-Kanal mittels einer Einstellvorrichtung (8) ausrichtbar ist.

5. TV-Empfänger nach einem der vorstehenden Ansprüche,
**dadurch gekennzeichnet,** daß der Speicher (7) ein Lesespeicher (9) darstellt.

6. TV-Empfänger nach einem der vorstehenden Ansprüche 2 bis 5,
**dadurch gekennzeichnet,** daß der Speicher (7) ein Lesespeicher (9) darstellt, dem ein zusätzlicher beschreibbarer Speicher (10) zugeordnet ist, der für das Abspeichern von zusätzlichen ortsspezifischen Informationen zur Relevanz bestimmter TV-Standards, zur Empfangbarkeit bestimmter TV-Kanäle und/oder zur Ausrichtung der TV-Antenne (3) und zum Auslesen dieser Information vorgesehen ist, und die ausgelesenen Informationen bei der Steuerung des TV-Tuners (4) oder der dem TV-Empfänger (1) zugeordneten TV-Antenne (3) heranziehbar sind.

7. TV-Empfänger nach einem der vorstehenden Ansprüche,
**dadurch gekennzeichnet,** daß der GPS-Empfänger (6) und die diesen zugeordnete GPS-Antenne (11) vom restlichen TV-Empfänger (1) abgesetzt ausgebildet sind.

8. TV-Empfänger nach einem der vorstehenden Ansprüche,
**dadurch gekennzeichnet,** daß der GPS-Empfänger (6) im Bereich der GPS-Antenne (11) angeordnet ist und der restliche TV-Empfänger (1) im Bereich der zugeordneten TV-Antenne (3) angeordnet ist und mit dem GPS-Empfänger über eine Datenleitung verbunden ist.
